Europäisches Patentamt

European Patent Office

Office européen des brevets

(19)

(11) Numéro de publication : **0 684 481 A1**

## (12) DEMANDE DE BREVET EUROPEEN

(21) Numéro de dépôt : **95401188.8**

(22) Date de dépôt : **22.05.95**

(51) Int. Cl.⁶ : **G01R 15/06**

(30) Priorité : **25.05.94 FR 9406332**

(43) Date de publication de la demande :
**29.11.95 Bulletin 95/48**

(84) Etats contractants désignés :
**AT CH DE ES GB IT LI SE**

(71) Demandeur : **GEC ALSTHOM T ET D SA**
**38, Avenue Kléber**
**F-75016 Paris (FR)**

(72) Inventeur : **Baudart, Christophe**
**65, Cours Vitton**
**F-69006 Lyon (FR)**
Inventeur : **Gris, Jean-Paul**
**7, Impasse de la reine**
**F-69005 Lyon (FR)**

(74) Mandataire : **Fournier, Michel et al**
**SOSPI**
**14-16, rue de la Baume**
**F-75008 Paris (FR)**

(54) **Suppression d'une composante perturbatrice.**

(57)    Procédé pour la suppression dans un signal périodique d'une composante perturbatrice, caractérisé en ce qu'il comprend les opérations suivantes :

— on effectue au moins une mesure du signal à deux instants différents,

— on calcule à partir desdites mesures les paramètres de la composante perturbatrice,

— on soustrait du signal ladite composante perturbatrice.

L'invention trouve application dans la réalisation d'un transformateur capacitif électronique de tension comprenant un diviseur capacitif constitué d'un condensateur haute tension (Ca) et un condensateur basse tension (Cb), caractérisé en ce qu'il comprend un microprocesseur ((14) programmé pour réaliser, sur le signal issu du condensateur basse tension (Cb), le procédé précité.

FIG. 3

La présente invention a trait à un procédé et à un dispositif permettant de supprimer dans un signal périodique une composante perturbatrice, le plus souvent exponentielle; l'invention trouve une application particulièrement intéressante dans le domaine des transformateurs capacitifs électroniques de tension et c'est cet exemple qui sera exposé dans la suite.

On rappelle qu'un transformateur capacitif électronique de tension (en abrégé TCET) est un appareil comprenant un diviseur capacitif utilisé pour la mesure de la tension d'une ligne (ou câble) électrique à haute ou très haute tension.

Une difficulté majeure rencontrée dans la mesure de la tension d'une ligne au moyen d'un TCET, comprenant notamment un condensateur haute tension Ca et un condensateur basse tension Cb, provient des charges qui, à l'ouverture d'une ligne, restent piégées sur la ligne; la ligne se comporte, à vide, comme un condensateur de forte valeur CL. Il en résulte une tension continue Up qui peut avoir une valeur élevée si l'ouverture de la ligne a eu lieu sur une crête de tension. Cette tension décroît exponentiellement, avec une constante de temps de l'ordre de un ou plusieurs jours, selon les diverses résistances de fuite, variables avec les conditions climatiques. Le condensateur Cb du TCET est rapidement déchargé par la résistance de polarisation R2 présente à ses bornes, tandis que le condensateur Ca reste chargé à la tension Up. Lors de la remise sous tension, la faible impédance du réseau, en courant continu, décharge quasi instantanément la ligne, effectuant ainsi un transfert de charge de Ca vers Cb qui se trouve alors chargé à une tension U2 égale à -Up.Ca/Cb.

Cette tension, qui décroît exponentiellement avec une constante de temps R2Cb, se superpose au signal sinusoïdal utile, et constitue une erreur très importante.

Il est décrit, dans le document EP-A-0 190 455, une méthode pour supprimer la composante continue perturbatrice lors du réenclenchement sur charges piégées. La méthode comprend les opérations d'estimation de la composante perturbatrice et d'addition de cette valeur estimée en opposition de phase avec le signal.

Dans ce document, les auteurs estiment que la composante perturbatrice est continue et quasiment constante. La méthode d'estimation de la composante perturbatrice utilisée est donc celle d'une valeur continue.

Cette méthode convient pour les matériels de type ouvert, dans lesquels les valeurs de capacités des diviseurs capacitifs sont élevées, entraînant une constante de temps très grande de la composante perturbatrice qui peut donc être assimilée à une composante de valeur quasiment constante. Cette méthode est mal adaptée à la correction d'une composante perturbatrice exponentielle à constante de temps de l'ordre de 100ms. La correction ne se fera qu'avec retard.

Un but de la présente invention est de définir un dispositif permettant de supprimer la composante perturbatrice qui survient dans les circuit utilisant du matériel de type blindé dans lesquels la composante perturbatrice est exponentielle, avec une constante de temps faible, typiquement 100 millisecondes.

L'invention a pour objet un procédé pour la suppression dans un signal périodique d'une composante perturbatrice, caractérisé en ce qu'il comprend les opérations suivantes:
- on effectue au moins deux mesures du signal à deux instants distincts,
- on calcule à partir desdites mesures les paramètres de la composante perturbatrice,
- on soustrait du signal ladite composante perturbatrice.

Avantageusement, on procède à une opération de filtrage du signal pour éliminer les hautes fréquences ou les harmoniques.

Dans un mode particulier de mise en oeuvre du procédé, on effectue un couple de mesures du signal à des instants séparés par une durée égale à $\pi/\omega$, où $\omega$ est la pulsation du signal périodique, et on calcule les paramètres de la composante perturbatrice par soustraction des deux mesures.

En variante, on effectue plusieurs couples de mesure du signal, les mesures dans chaque couple étant effectuées à des instants séparés de $\pi/\omega$, les paramètres de la composante perturbatrice étant déduits des résultats obtenus pour chaque couple de mesure, par exemple en effectuant la moyenne.

L'invention a également pour objet un dispositif pour la mise en oeuvre du procédé précité, caractérisé en ce qu'il comprend un microprocesseur recevant le signal et programmé pour effectuer au moins deux mesures du signal à des instants distincts, pour calculer à partir desdites mesures les paramètres de la composante perturbatrice, et pour soustraire du signal ladite composante perturbatrice.

L'invention a également pour objet un transformateur capacitif électronique de tension comprenant un diviseur capacitif constitué d'un condensateur haute tension et un condensateur basse tension, caractérisé en ce qu'il comprend un microprocesseur programmé pour réaliser, sur le signal issu du condensateur basse tension, le procédé précité.

L'invention est expliquée maintenant en détail avec référence au dessin annexé dans lequel:
- la figure 1 est un schéma équivalent d'une ligne et d'un transformateur capacitif électronique de tension (TCET),
- la figure 2A est un diagramme montrant la tension aux bornes du condensateur haute tension d'un TCET lors de manoeuvres de déclenchement et de réenclenchement successifs,

- la figure 2B est un diagramme correspondant pour la tension aux bornes du condensateur basse tension du TCET,
- la figure 3 est un schéma d'un transformateur capacitif électronique de tension (TCET),
- la figure 4 est un diagramme montrant l'allure du signal périodique perturbé par une composante exponentielle ainsi que l'allure du signal corrigé.

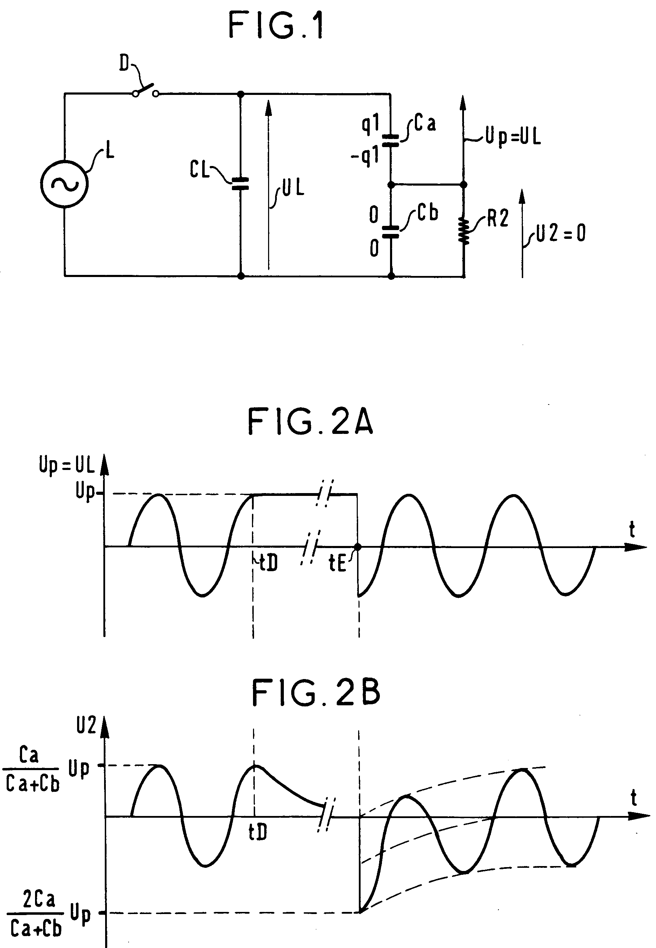

Dans la figure 1, la référence L désigne une ligne (ou câble) alternatif avec un disjoncteur D.

Les figures 1, 2A et 2B illustrent l'explication qui a été donnée plus haut sur l'apparition au réenclenchement de la composante exponentielle perturbatrice et il est inutile de les commenter davantage. Les abscisses tD et tE correspondent respectivement aux instants du déclenchement et du réenclenchement du disjoncteur.

Le procédé de l'invention comprend une première phase de détection du rétablissement de le tension de la ligne et d'estimation des paramètres de la composante exponentielle, et une deuxième phase de correction du signal de mesure par soustraction de la composante exponentielle estimée.

La détection de présence de la tension peut être effectuée par exemple par un filtre sélectif à la fréquence de la ligne (50 ou 60 Hz selon les réseaux), suivi par un détecteur de crête et un seuillage à hystérésis.

La détection de tension lors d'un réenclenchement active un dispositif d'estimation des paramètres de la composante exponentielle. Le principe d'établissement de cette estimation est expliqué maintenant.

Au réenclenchement, le signal de sortie u(t) aux bornes du condensateur basse tension Cb est de la forme:

$$u(t) = A \cos(\omega t + \phi) + B \exp(-t/\tau)$$

expression dans laquelle:

$A \cos(\omega t + \phi)$ est la composante utile du signal

$B \exp(-t/\tau)$ est la composante perturbatrice

Si on mesuree le signal u(t) à deux instants successifs t1 et t1+π/ω, on obtient:

$$u(t1) = A \cos(\omega t1 + \phi) + B \exp(-t1/\tau)$$

$$u(t1 + \pi/\omega) = A\cos(\omega t1 + \phi + \pi) + B\exp(-(t1 + \pi/\omega)/\tau)$$
$$= -A\cos(\omega t1 + \phi) + B\exp(-t1/\tau)\exp(-\pi/\omega/\tau)$$

En additionnant terme à terme les égalités ci-dessus:

$$u(t1) + u(t1 + \pi/\omega) = (1 + \exp(-\pi/\omega/\tau)) . B\exp(-t1/\tau)$$

Le coefficient B est donc égal à:

$$(u(t1) + u(t1 + \pi/\omega))/[(1 + \exp(-\pi/\omega/\tau)) . \exp(-t1/\tau)]$$

La connaissance de B permet de caractériser la perturbation.

On note que cette estimation de B est faite avec l'hypothèse que le signal u(t) est bien de la forme indiquée plus haut.

En cas de présence suplémentaire de hautes fréquences ou d'harmoniques, il pourra être nécessaire:

- soit de filtrer préalablement le signal u(t)
- soit de calculer la valeur de B pour plusieurs couples de valeurs t1 et t1 + π/ω et de prendre une valeur moyenne.

Bien entendu, la mesure du signal à deux instants séparés de π/ω n'est qu'un exemple qui facilite le calcul. Plus généralement, on peut mesurer le signal à deux instants quelconques distincts et, par calcul, en déduire la valeur des paramètres de la composante perturbatrice. On peut, pour une plus grande précision, effectuer plus de deux mesures du signal à des instants distincts. On peut aussi effectuer plusieurs couples de mesures à des instants séparés, dans chaque couple, de π/ω et, par exemple en effectuant la moyenne ou par toute autre méthode, en déduire la valeur des paramètres de la composante perturbatrice.

La connaissance de B permet d'élaborer un signal Bexp(-t/τ) qu'on retranche au signal reçu u(t). On obtient ainsi un signal corrigé de la composante exponentielle perturbatrice.

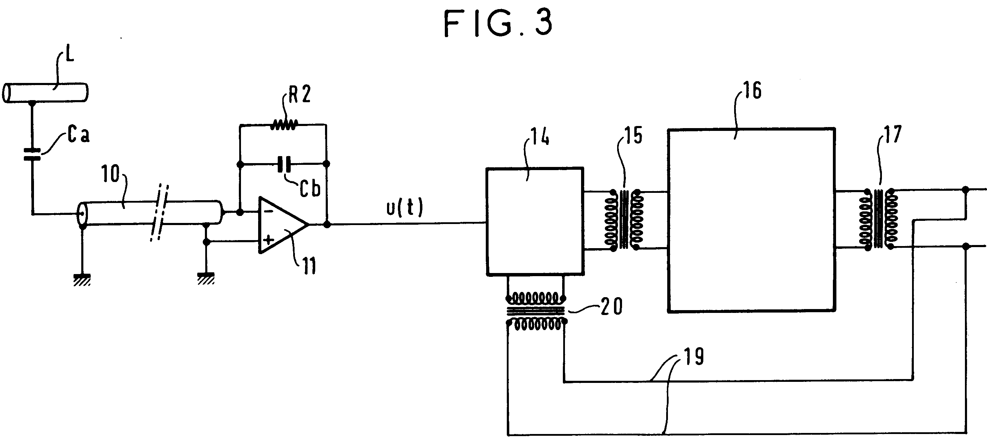

La figure 3 est un schéma de réalisation pratique d'un TCET muni du dispositif de correction de l'invention. On pourra se référer par exemple au brevet français n° 89 11 761 du 8 septembre 1989 qui décrit un réducteur de tension capacitif dont est issu l'appareil présenté maintenant.

La référence L désigne la ligne dont on mesure la tension. Le condensateur Ca est relié d'une part à la ligne L et d'autre part, par un câble coaxial 10 à l'entrée négative d'un amplificateur opérationnel 11. Le condensateur basse tension Cb en parallèle avec une résistance R2, est reliée entre cette entrée négative et la sortie de l'amplificateur.

L'entrée positive de l'amplificateur est reliée à la terre.

Le signal de sortie de l'amplificateur u(t) est adressé à l'entrée d'un bloc de traitement de signal 14, par exemple un microprocesseur, dont le rôle est notamment d'effectuer les opérations relatives à la correction dont le principe a été expliqué plus haut : détection de l'apparition du signal, échantillonnage du signal, calcul

3

EP 0 684 481 A1

des paramètres de la composante perturbatrice, soustraction au signal de ladite composante perturbatrice et fourniture du signal utile.

Le dispositif est complété par un transformateur d'isolement, un amplificateur de puissance 16 et un transformateur de puissance 17 aux bornes duquel on recueille le signal corrigé et amplifié. L'amplificateur est doté d'une boucle de contre-réaction 19 comprenant un transformateur de contre-réaction 20; la stabilité est assurée par le microprocesseur 14, comme il a été décrit dans le brevet français n° 89 11 386 du 30 août 1989.

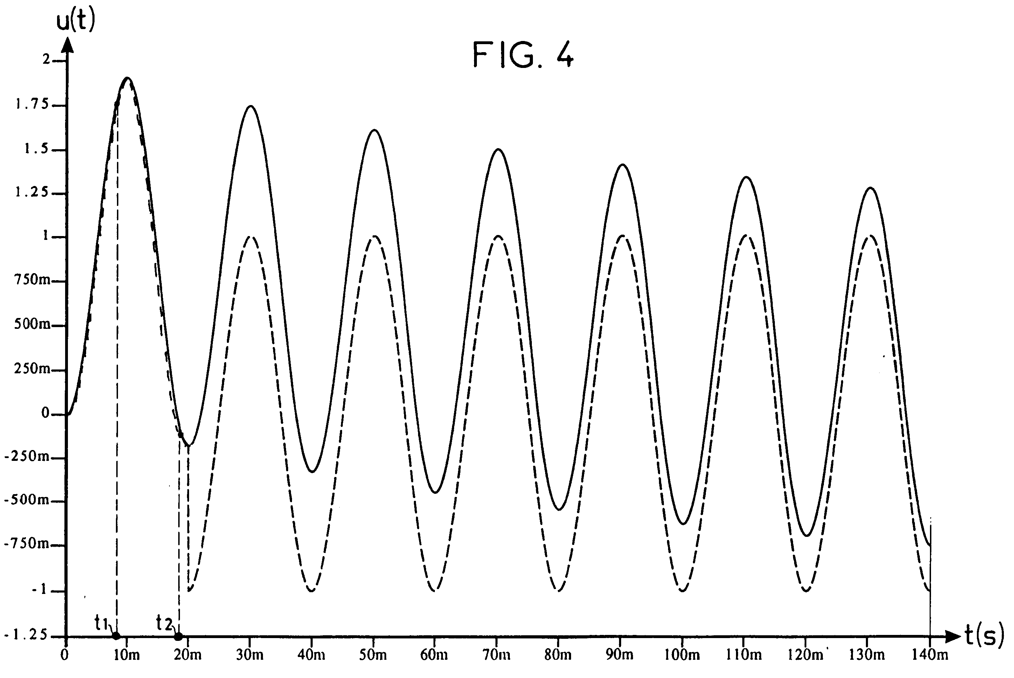

La figure 4 est un diagramme montrant l'excellence de la correction. La courbe en traits pleins correspond au signal non corrigé; la courbe en tiretés correspond au signal après correction.

Les abscisses tl, à 8 millisecondes (arbitraire) et t2, à 18 millisecondes (soit t1 + $\pi/\omega$ à 50 Hz), correspondent aux instants des deux mesures du signal u(t).

Le signal corrigé est, quasi immédiatement après l'instant t2, débarrassé de sa composante perturbatrice.

On notera que la méthode utilisée dans l'art antérieur précité est une méthode purement linéaire (à la numérisation du signal près). En effet, l'algorithme numérique est mis en oeuvre par un simple filtre récursif. Il en découle que la branche de correction doit aussi avoir un effet de rotation de phase sur la composante à 50 Hz, pénalisant la précision du réducteur de mesure.

Le dispositif de l'invention estime la composante perturbatrice par une méthode non linéaire sans influence aucune sur la précision à 50 Hz, permettant au réducteur de mesure d'avoir non seulement la précision nécessaire à la protection, mais aussi la précision, plus grande, exigée pour les mesures.

L'invention s'applique à tous les circuits électroniques de mesure dont le signal de sortie est perturbé par une composante apériodique de faible constante de temps.

**Revendications**

1/ Procédé pour la suppression dans un signal périodique d'une composante perturbatrice, caractérisé en ce qu'il comprend les opérations suivantes:
- on effectue au moins deux mesures du signal à deux instants distincts,
- on calcule à partir desdites mesures les paramètres de la composante perturbatrice,
- on soustrait du signal ladite composante perturbatrice.

2/ Procédé selon la revendication 1, caractérisé en ce que on procède à une opération de filtrage du signal pour éliminer les hautes fréquences ou les harmoniques.

3/ Procédé selon l'une des revendications 1 et 2, caractérisé en ce qu'on effectue un couple de mesures du signal à des instants séparés par une durée égale à $\pi/\omega$, où $\omega$ est la pulsation du signal périodique, et qu'on calcule les paramètres de la composante perturbatrice par soustraction des deux mesures.

4/ Procédé selon l'une des revendications 1 et 2, caractérisé en ce qu'on effectue plusieurs couples de mesure du signal, les mesures dans chaque couple étant effectuées à des instants séparés de $\pi/\omega$, les paramètres de la composante perturbatrice étant déduits des résultats obtenus pour chaque couple de mesure, par exemple en effectuant la moyenne.

5/ Dispositif pour la mise en oeuvre du procédé selon les revendications 1 à 4, caractérisé en ce qu'il comprend un microprocesseur recevant le signal et programmé pour effectuer au moins deux mesures du signal à des instants distincts, pour calculer à partir desdites mesures les paramètres de la composante perturbatrice, et pour soustraire du signal ladite composante perturbatrice.

6/ Transformateur capacitif électronique de tension comprenant un diviseur capacitif constitué d'un condensateur haute tension (Ca) et un condensateur basse tension (Cb), caractérisé en ce qu'il comprend un microprocesseur (14) programmé pour réaliser, sur le signal issu du condensateur basse tension (Cb), le procédé selon les revendications 1 à 3.

4

# FIG.1

# FIG.2A

# FIG.2B

# FIG.3

EP 0 684 481 A1

FIG. 4

EP 0 684 481 A1

Office européen
des brevets

**RAPPORT DE RECHERCHE EUROPEENNE**

Numero de la demande

EP 95 40 1188

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | EP,A,0 190 455 (MWB) *résumé* * figure 1 * | 1 | G01R15/06 |
| A | GB,A,2 102 972 (GENERAL ELECTRIC) * figure 5 * | 1 | |
| D,A | EP,A,0 415 313 (GEC ALSTROM) | 1 | |
| D,A | FR,A,2 651 889 (GEC ALSTROM) | 1 | |
| A | GB,A,2 234 133 (MITSUBISHI) * figure 1 * | 1 | |
| A | DATABASE WPI Week 7924 Derwent Publications Ltd., London, GB; AN 79-F2999B Ç24! & SU,A,620 030 (ATAKHANOV) , 28 Juin 1978 * abrégé * | 1 | |

DOMAINES TECHNIQUES RECHERCHES (Int.Cl.6)

G01R

Le présent rapport a été établi pour toutes les revendications

| Lieu de la recherche | Date d'achèvement de la recherche | Examinateur |
|---|---|---|
| LA HAYE | 24 Juillet 1995 | Hoornaert, W |

EPO FORM 1503 03.82 (P04C02)